**Europäisches Patentamt**

**European Patent Office**

**Office européen des brevets**

(19)

(11) Veröffentlichungsnummer: **0 047 825
B1**

(12)

# EUROPÄISCHE PATENTSCHRIFT

(45) Veröffentlichungstag der Patentschrift:
03.10.84

(51) Int. Cl.³: **H 03 F 1/33**

(21) Anmeldenummer: **81105269.5**

(22) Anmeldetag: **08.07.81**

(54) Verfahren zur breitbandigen Linearisierung von Mikrowellenverstärkern.

(30) Priorität: **04.09.80 DE 3033288**

(43) Veröffentlichungstag der Anmeldung:
**24.03.82 Patentblatt 82/12**

(45) Bekanntmachung des Hinweises auf die Patenterteilung:
**03.10.84 Patentblatt 84/40**

(84) Benannte Vertragsstaaten:
**AT DE FR GB IT**

(56) Entgegenhaltungen:
**DE - A - 1 766 313
DE - A - 2 147 167
DE - A - 2 304 352
DE - C - 1 289 140
US - A - 3 755 754
US - A - 4 068 186
US - A - 4 122 399**

**NACHRICHTENTECHN. Z. (ntz) ARCHIV, Nr. 1, 1979,
Berlin H.J. HEUN et al. "Two.stage Predistortion - a
Method to Reduce the Nonlinearities of Microwave
Power Amplifiers"
Proceedings of the IEEE, Feb. 1971, Seite 230-238
IEEE-ICC 1980, Seattle, Band 2, 33.2.1-33.2.6**

(73) Patentinhaber: **ANT Nachrichtentechnik GmbH,
Gerberstrasse 33, D-7150 Backnang (DE)**

(72) Erfinder: **Egger, Alois, Prof. Dr.-Ing., Darmstädter
Strasse 86, D-7000 Stuttgart 50 (DE)**
Erfinder: **Vien, Tong, Dipl.-Ing., Gründgensstrasse 54,
D-7000 Stuttgart 80 (DE)**

(74) Vertreter: **Schickle, Gerhard, Dipl.-Ing. et al, ANT
Nachrichtentechnik GmbH Patent- und Lizenzabteilung
Gerberstrasse 33, D-7150 Backnang (DE)**

## Beschreibung

Die Erfindung betrifft ein Verfahren zur breitbandigen Linearisierung von Mikrowellensendeverstärkern, insbesondere von Wanderfeldröhren nach dem Prinzip der Signalvorverzerrung mittels Verzerrungsnetzwerken, wobei eine amplituden- und phasenmässige Vorverzerrung in Abhängigkeit von der Eingangsamplitude erfolgt, so dass insgesamt eine lineare Verstärkung entsteht und wobei die zu verstärkende Signaleingangsspannung mittels eines Verzerrungsnetzwerkes derart verzerrt wird, dass die Ausgangsspannung des Verzerrungsnetzwerkes mit zunehmender Signaleingangsspannung überproportional ansteigt und zwar dergestalt, dass die Ausgangsspannung des Verzerrungsnetzwerkes den Mikrowellensendeverstärker dem Betrage nach linearisiert. Eine Vorrichtung, die auf einem solchen Verfahren beruht, ist aus der DE-A-2 147 167 bekannt. Die Vorverzerrung erfolgt dort in der Hochfrequenzebene.

Hochfrequenzverstärker haben, wie jeder Verstärker, eine maximale Ausgangsleistung, die nicht überschritten werden kann. Im allgemeinen verläuft die Verstärkerkennlinie so, dass bei kleiner Eingangsleistung die Ausgangsleistung proportional dazu ist. Mit zunehmender Eingangsleistung tritt eine Kompression des Ausgangssignals ein, gleichzeitig tritt eine immer grösser werdende Phasenverschiebung zwischen Eingangs- und Ausgangssignal auf. Diese Verstärkereigenschaft ist bei der Übertragung von amplitudenmodulierten Signalen äusserst schädlich und bringt grosse Signalverzerrungen. Bei gleichzeitiger Übertragung mehrerer Signale mittels eines Verstärkers tritt zusätzlich starkes Nebensprechen zwischen den einzelnen Kanälen durch Kreuzmodulation auf.

Um einen Hochfrequenzverstärker auch für die Übertragung grösserer Leistung unter Beachtung der tolerierbaren Verzerrungen einsetzen zu können, muss er linearisiert werden. Die bei niedrigen Frequenzen angewandte Gegenkoppelung ist bei Mikrowellenverstärkern nicht mehr möglich; relativ einfach lässt sich aber die Linearisierung nach dem Prinzip der Signalvorverzerrung durchführen. Aus der US-A-4 068 186 ist eine Vorrichtung nach dem Prinzip der Vorverzerrung bekannt, bei der das Eingangssignal amplituden- und phasenmässig vorverzerrt wird, um eine Linearisierung eines Mikrowellenverstärkers zu ermöglichen. Die Vorverzerrung erfolgt hierbei aber in Abhängigkeit der Frequenz und nicht in Abhängigkeit von der Eingangsamplitude.

Aus der Veröffentlichung «Two-stage predistortion – a method to reduce the nonlinearities of microwave power amplifiers» von H.J. Heun und K. Kiesel, NTZ Archiv (1979), Heft 1, Seite 19–23, ist ebenfalls ein Verfahren zur Linearisierung von Mikrowellensendeverstärkern nach dem Prinzip der Signalvorverzerrung in der Zwischenfrequenzebene bekannt. Hierbei werden mittels Kopplern aus dem Signalhauptweg Signalanteile in Signalnebenwege ausgekoppelt und in Hilfsverstärkern, deren Verzerrungscharakteristiken der Verzerrungscharakteristik des zu entzerrenden Hauptverstärkers entsprechen, verstärkt. Die mittels der Hilfsverstärker vorverzerrten Signale werden den unverzerrten Signalen im Signalhauptweg so überlagert, dass die Kompression des Ausgangssignals durch den Mikrowellenverstärker weitgehendst ausgeglichen wird. Amplitudenabhängige Phasennichtlinearitäten können mit diesem Verfahren nicht ausgeglichen werden. Ausserdem sind an die Linearitäten der Hilfsverstärker hohe Anforderungen zu stellen. Diese Methode ist nicht für alle Typen von Wanderfeldröhren geeignet. Insbesondere bereitet sie Schwierigkeiten bei Wanderfeldröhren für die Satellitentechnik, beispielsweise für die Wanderfeldröhren der Typenreihe TL 3050 bis 60 010. Bei der vorliegenden Erfindung wird deshalb ein anderer Weg für die Vorverzerrung beschritten.

In der Veröffentlichung «Effects of Intermodulation, AM-PM Conversion and Additive Noise in Multicarrier TWT Systems» von Osamu Shimbo, Proceedings of the IEEE, Vol. 59, No. 2, Februar 1971, Seite 230–238, wird eine Linearisierung für Wanderfeldröhren vorgeschlagen, wobei die Amplitudenlinearisierung nach der Verstärkung durch die Wanderfeldröhre vorgenommen wird. Zur Entzerrung der durch die AM-PM Konversion hervorgerufenen Verzerrungen wird nach Fig. 5 dieser Veröffentlichung das zu verstärkende Eingangssignal gleichgerichtet, verstärkt und mit diesem gleichgerichteten und verstärkten Signal die Vorspannung eines Varaktors verändert. Anschliessend wird das zu verstärkende Eingangssignal wie auch das Ausgangssignal des Varaktors über einen Zirkulator auf den Eingang der Wanderfeldröhre geschaltet. Die Änderung der Varaktorvorspannung ändert die Phase des Signals am Eingang der Wanderfeldröhre zur Unterdrückung der durch die AM-PM Konversion hervorgerufenen Verzerrungen. Der Aussteuerbereich des Varaktors muss bei dieser Methode zur Entzerrung optimal linear in Abhängigkeit der Frequenz sein, da das zu verstärkende Eingangssignal in der Hochfrequenzebene vorliegt. Dementsprechend müssen an die Kennlinie des Varaktors auch sehr hohe Anforderungen gestellt werden. Die Linearisierung muss hier sehr breitbandig sein, was einen grossen Aufwand bedeutet.

Der Erfindung eingangs genannter Art liegt die Aufgabe zugrunde, die Linearisierung so vorzunehmen, dass sowohl die Amplitudenverzerrungen wie auch die Phasenverzerrungen des Mikrowellenverstärkers unterdrückt werden, wobei bei der Frequenzumsetzung von der Zwischenfrequenzebene in die Hochfrequenzebene eine Frequenzabhängigkeit des Linearisierungsnetzwerkes vermieden werden soll.

Diese Aufgabe wird erfindungsgemäss durch die kennzeichnenden Merkmale des Patentanspruches 1 gelöst.

Vorteilhafte Weiterbildungen der Erfindung sind durch die Unteransprüche gekennzeichnet.

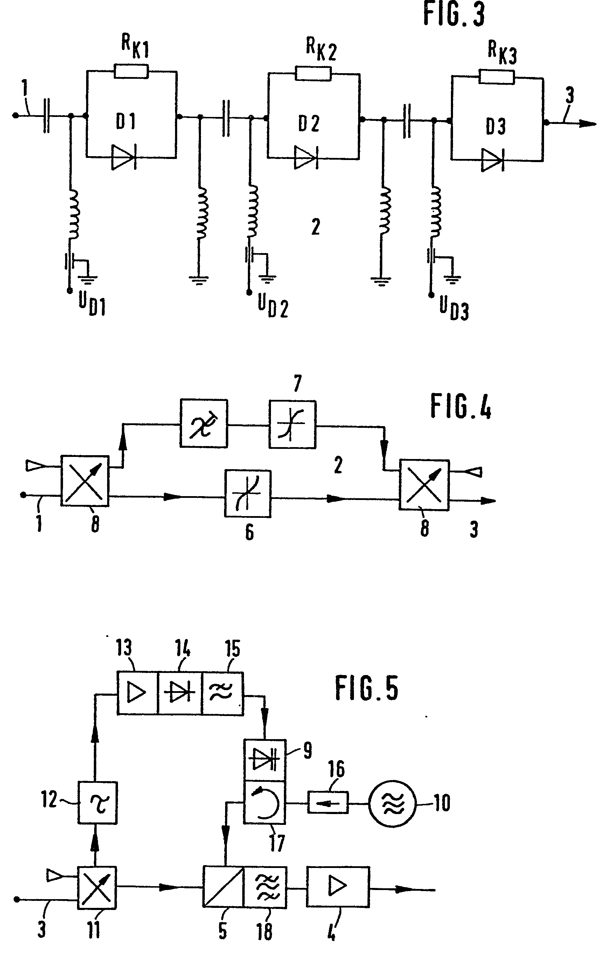

Aus der Veröffentlichung «Predistortion non-linear compensation for microwave SSB-AM systems» von Toshio Nojima und Yoshiharu Okamoto, IEEE-International Communication Conference, 1980, Seattle, Band 2, 33.2.1–33.2.6, Fig. 5 nebst zugehöriger Beschreibung, ist es zwar bekannt, die Vorverzerrung für einen Wanderfeldröhrenverstärker in der Zwischenfrequenzebene vorzunehmen. Die in diesem Artikel vorgeschlagene Methode zur Entzerrung von Kennlinien ist aber nur für bestimmte Wanderfeldröhrentypen brauchbar und zwar für solche, die wenig Amplitudennichtlinearitäten aufweisen und deren Phasennichtlinearitäten dergestalt sind, dass die Intermodulationsverzerrungen konstante Phasenlage im ganzen Aussteuerbereich in Bezug auf die Grundwelle aufweisen.

Die Erfindung soll nun anhand der Zeichnungen näher erläutert werden. Dabei zeigt

Fig. 1 die Ausgangsleistung $P_o$ als Funktion der Eingangsleistung $P_i$ und die Änderung der relativen Phase bei einer Wanderfeldröhre,

Fig. 2 die Soll-Kurve der Amplitudenvorverzerrung und mögliche Annäherungen durch verschiedene Vorverzerrungsnetzwerke,

Fig. 3 ein Amplitudenvorverzerrungsnetzwerk mit Dioden,

Fig. 4 ein Amplitudenvorverzerrungsnetzwerk, dessen Teilnetzwerke Kompressor- und Expandercharakteristiken aufweisen,

Fig. 5 ein Blockschaltbild zur Erzeugung der amplitudenabhängigen Phasenvorverzerrung,

Fig. 6a das Ausgangsspektrum eines Wanderfeldröhrenverstärkers ohne Linearisierung und

Fig. 6b das Ausgangsspektrum eines Wanderfeldröhrenverstärkers mit Linearisierung.

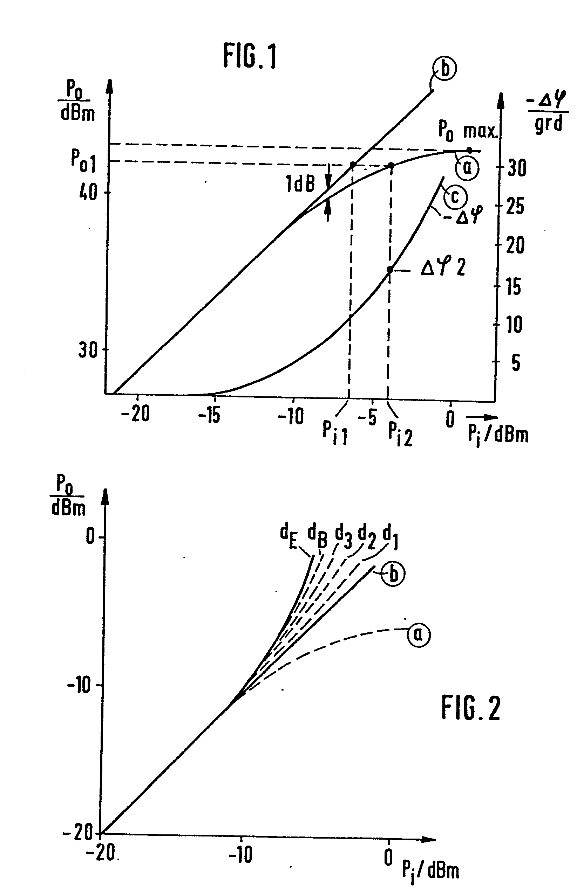

In Fig. 1 zeigt die Kennlinie ⓐ die Funktion der Eingangsleistung $P_i$ zur Ausgangsleistung $P_o$ bei einer typischen Wanderfeldröhre, die als Mikrowellensendeverstärker benutzt wird. Wie aus Fig. 1 ersichtlich ist, ergeben sich starke Abweichungen vom gewünschten proportionalen Zusammenhang, Kennlinie b , zwischen $P_o$ und $P_i$, besonders bei hoher Aussteuerung. Die Kennlinie ⓒ zeigt den Verlauf der relativen Phasenänderung $\triangle \varphi$ in Bezug zur Eingangsleistung $P_i$. Es tritt bei zunehmender Eingangsleistung eine Kompression des Ausgangssignals ein, gleichzeitig ändert sich die Phase um einen Winkel $\triangle \varphi$.

Das Prinzip der Signalvorverzerrung sei nun anhand von Fig. 1 näher erläutert. Es sei angenommen, die grösste zu übertragende Ausgangsleistung sei $P_{o1}$. Wenn der Verstärker linear wäre, müsste das Eingangssingal die Leistung $P_{i1}$ aufweisen. Um nun die Kompression der Verstärkerkennlinie ⓐ auszugleichen, muss auf den Verstärkereingang die grössere Leistung $P_{i2}$ gegeben werden und der Phasenwinkel dieses Signals gleichzeitig um den Betrag $\triangle \varphi_2$ verkleinert werden, damit der Phasenfehler der Wanderfeldröhre wieder ausgeglichen wird.

Diese Linearisierung wird in zwei Stufen vorgenommen; betragsmässige und phasenmässige Entzerrung.

Zur betragsmässigen Entzerrung eines Verstärkers mit der Kennlinie ⓐ muss auf seinen Eingang ein Signal mit einer Expandercharakteristik, Kennlinie $d_E$ in Fig. 2 gegeben werden; d.h. die Ausgangsspannung 3 eines Verzerrungsnetzwerkes 2 muss mit zunehmender Signaleingangsspannung 1 überproportional ansteigen (vgl. Fig. 3). Die Vorverzerrung dem Betrage nach, Amplitudenvorverzerrung, wird dabei in der Zwischenfrequenzebene vorgenommen. Eine Expandercharakteristik lässt sich mit Hilfe einer Diode, die mit einem Widerstand überbrückt ist, erzielen. Schaltet man mehrere Dioden in Serie, so kann mit Hilfe einer Vorspannung, die jeder Diode getrennt zugeführt wird, die gewünschte Amplitudencharakteristik angenähert werden. Fig. 3 zeigt ein Dioden-Widerstandsvorverzerrungsnetzwerk 2 zur Linearisierung der Amplitudencharakteristik. Die zu verstärkende Signaleingangsspannung 1 gelangt über einen Koppelkondensator auf die mit einem Widerstand $R_{k1}$ überbrückte Diode D1. Die Vorspannung $U_{D1}$ für die Diode D1 wird über eine Induktivität zugeführt. An das aus D1 und $R_{k1}$ bestehende Netzwerk schliessen sich bedarfsweise noch weitere Netzwerke $R_{k2}$, D2; $R_{k3}$, D3;.. in Serienschaltung an. Die getrennten Vorspannungen $U_{D1}$, $U_{D2}$, $U_{D3}$,.. werden so eingestellt, dass sich die Kennlinie ⓐ der Wanderfeldröhre möglichst weitgehend linearisieren lässt. Die dazu entsprechenden Kennlinien sind in Fig. 2 eingetragen und mit $d_1$ ... $d_3$ bezeichnet. Am Ausgang des Vorverzerrungsnetzwerkes 2 von Fig. 3 steht die Ausgangsspannung 3 zur phasenmässigen Entzerrung zur Verfügung.

Eine bessere Annäherung an die Sollkurve, Expandercharakteristik-Kennlinie $d_E$ (Fig. 2), über einen grossen Dynamikbereich lässt sich mit einem Verzerrungsnetzwerk 2, wie es in Fig. 4 dargestellt ist, realisieren.

Die zu verstärkende Signaleingangsspannung 1 wird mit einer Gabelschaltung 8 auf zwei Wege aufgeteilt. Im einen Signalweg liegt ein Verzerrungsteilnetzwerk mit Expandercharakteristik 6, im anderen Signalweg ein Verzerrungsteilnetzwerk mit Kompressorcharakteristik 7. In einer weiteren Gabelschaltung 8 werden die verschiedenen vorverzerrten Signale wieder zu einer Ausgangsspannung 3 phasenrichtig zusammengefasst. Eine Laufzeitleitung $\tau$ im Signalweg des Teilnetzwerkes mit Kompressorcharakteristik 7 gleicht dabei unterschiedliche Signallaufzeiten aus. Auch dieses Vorverzerrungsnetzwerk ist in der Zwischenfrequenzebene realisiert. Seine Kennlinie ist in Fig. 2, Kennlinie $d_B$, eingetragen. Die Gabelschaltungen 8 bestehen aus Vier-Tor-Kopplern. Jeweils ein Tor eines Kopplers 8 wird reflexionsfrei abgeschlossen.

Die im Zwischenfrequenzbereich realisierte Verzerrungsschaltung lässt sich exakt justieren und verbessert gleichzeitig die Amplitudennichtlinearität der gesamten Sendeeinrichtung, also des Zwischenfrequenzverstärkers, des Umsetzers und des Wanderfeldröhrenverstärkers.

Zur pegelabhängigen Drehung des Phasenwinkels des Eingangssignals des Mikrowellensendeverstärkers (Wanderfeldröhre) 4, um den Winkel $\triangle \varphi$ wird eine Anordnung gemäss Fig. 5 verwendet. Dazu wird das Ausgangssignal 3 des Vorverzerrungsnetzwerkes 2, Realisierung gemäss Fig. 3 oder Fig. 4, auf den Eingang eines Vier-Tor-Kopplers 11 gegeben. Ein Ausgang des Kopplers 11 ist mit dem Umsetzer 5 verbunden, der das betragsmässig vorverzerrte Signal der Zwischenfrequenzebene in die Hochfrequenzebene umsetzt. Ein Teil des betragsmässig vorverzerrten Signals der Zwischenfrequenzebene wird an einem anderen Ausgang des Kopplers 11 entnommen. Nach Durchlaufen einer Laufzeitleitung 12 und Verstärkung mittels Verstärker 13 wird es mittels Gleichrichter 14 linear gleichgerichtet (envelope-detector). Die so gewonnene Spannung steuert nach Oberwellenbefreiung durch Tiefpass 15 einen Phasenmodulator 9 und damit auch die Phase des Hilfsoszillators 10. Der Hilfsoszillator 10, der das Umsetzoszillatorsignal für den Umsetzer 5 erzeugt, ist über eine Richtungsleitung 16 mit einem Tor eines Zirkulators 17 verbunden. Ein anderes Tor des Zirkulators 17 ist mit dem Phasenmodulator 9 verbunden. Am Ausgang des Zirkulators 17 steht das durch das gleichgerichtete Steuersignal in der Phase beeinflusste Umsetzoszillatorsignal zur Verfügung, welches den Umsetzer 5 ansteuert. Die Richtungsleitung 16 dient zur Vermeidung von Rückwirkungen des Umsetzoszillatorsignales auf den Hilfsoszillator 10.

Der Phasenwinkel des Umsetzoszillatorsignals wird mit dieser Anordnung genau um den nach Fig. 1 erforderlichen Winkel $\triangle\varphi_2$ verändert. Damit ändert sich der Phasenwinkel des Hochfrequenzsignals am Umsetzerausgang um den gleichen Betrag.

Dadurch, dass das Steuersignal für den Phasenmodulator 9 zusätzlich frequenzabhängig in der Amplitude beeinflusst wird, kann die Frequenzabhängigkeit des Mikrowellenverstärkers 4 kompensiert werden und eine breitbandige Linearisierung ermöglicht werden.

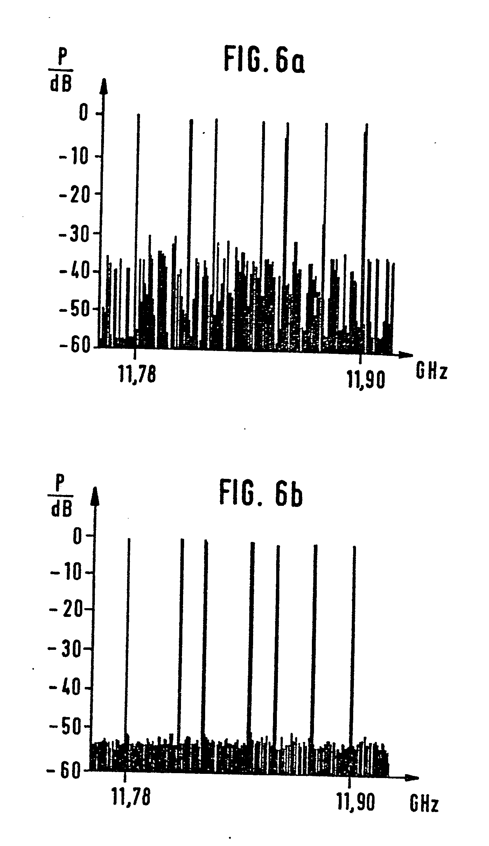

Fig. 6a zeigt das Ausgangsspektrum von sieben unmodulierten Trägern, die einen nichtlinearisierten Mikrowellensendeverstärker ansteuern. Für das belegte Frequenzband von 120 MHz mit der tiefsten Übertragungsfrequenz von 11,78 GHz wurden ungleiche Frequenzabstände eingestellt. Dadurch lässt sich die sehr grosse Zahl der durch die nichtlinearen Verzerrungen 3. Ordnung entstehenden Störfrequenzen erkennen. Der Abstand zwischen der Träger- und Störleistung beträgt im Mittel 35 dB.

In Fig. 6b sind die Vorverzerrungsnetzwerke für Amplitude und Phase eingeschaltet. Die Störlinien sind um mehr als 25 dB abgesenkt und durch das Eigenrauschen des Spektrumanalysators verdeckt. Bei Absenkung der Leistung jedes Einzelträgers um 6 dB wird der Abstand der Störlinien um 12 dB grösser, aber im allgemeinen ist dann das Verhältnis von Nutzsignal zu Störsignal immer noch ausreichend.

**Patentansprüche**

1. Verfahren zur breitbandigen Linearisierung von Mikrowellensendeverstärkern, insbesondere von Wanderfeldröhren, nach dem Prinzip der Signalvorverzerrung mittels Verzerrungsnetzwerken, wobei eine amplituden- und phasenmässige Vorverzerrung in Abhängigkeit von der Eingangsamplitude erfolgt, so dass insgesamt eine lineare Verstärkung entsteht und wobei die zu verstärkende Signaleingangsspannung (1) mittels eines Verzerrungsnetzwerkes (2) derart verzerrt wird, dass die Ausgangsspannung (3) des Verzerrungsnetzwerkes (2) mit zunehmender Signaleingangsspannung (1) überproportional ansteigt und zwar dergestalt, dass die Ausgangsspannung (3) des Verzerrungsnetzwerkes (2) den Mikrowellensendeverstärker (4) dem Betrage nach linearisiert, dadurch gekennzeichnet, dass die amplitudenmässige Vorverzerrung in der Zwischenfrequenzebene erfolgt, und dass bei der nachfolgenden Frequenzumsetzung des dem Betrage nach vorverzerrten Signals in die Hochfrequenzebene zusätzlich die Phase der Schwingung des den Umsetzer (5) steuernden Umsetzoszillators (10) von einem aus dem zu verstärkenden Singal abgeleiteten Steuersignal so beeinflusst wird, dass insgesamt eine lineare Verstärkung entsteht.

2. Verfahren nach Anspruch 1, dadurch gekennzeichnet, dass der überproportionale Anstieg der Ausgangsspannung (3) des Verzerrungsnetzwerkes (2) dadurch erreicht wird, dass die zu verstärkende Eingangsspannung (1) auf zwei Wege aufgeteilt wird, wobei in den einen Weg ein Verzerrungsteilnetzwerk mit Expandercharakteristik (6) und in den anderen Weg ein Verzerrungsteilnetzwerk mit Kompressorcharakteristik (7) eingeschaltet wird und dass die Ausgangssignale der beiden Verzerrungsteilnetzwerke mit einer Gabelschaltung (8) wieder zu einer Ausgangsspannung zusammengefasst werden.

3. Verfahren nach Anspruch 1 oder 2, dadurch gekennzeichnet, dass die Ausgangsspannung (3) des Verzerrungsnetzwerkes (2) linear gleichgerichtet wird, dass mit dieser gleichgerichteten Spannung ein Phasenmodulator (9) gesteuert wird, der den Phasenwinkel eines Hilfsoszillators (10) ändert und dass mit dem Ausgangssignal des Phasenmodulators (9), das als Umsetzoszillatorsignal benutzt wird, der Umsetzer (5) so angesteuert wird, dass die durch den Mikrowellensendeverstärker (4) und die durch die Vorverzerrung dem Betrage nach verursachten Phasenfehler kompensiert werden.

**Revendications**

1. Procédé de linéarisation en bande large d'amplificateurs mocro-onde, en particulier de tubes à propagation d'ondes, selon le principe de la prédistorsion du signal au moyen de réseaux de distorsion, une prédistorsion en amplitude et en phase se faisant en fonction de l'amplitude du signal d'entrée de telle sorte qu'au total il se produit une amplification linéaire; et la tension (1) d'entrée du signal à amplifier (1) au moyen d'un réseau de distorsion (2) subissant une distorsion de façon telle que la tension de sortie (3) du réseau de distorsion (2) croît plus que proportionellement pour une tension croissante d'entrée du signal (1) et, de façon plus précise, de façon telle que la tension de sortie (3) du réseau de distorsion (2) linéarise en valeur (en amplitude) l'amplificateur émetteur micro-onde (4), caractérisé en ce que la prédistorsion en amplitude a lieu dans le plan de fréquence intermédiaire; et en ce que, lors de la conversion, qui suit en le plan haute fréquence du signal qui a subi cette prédistorsion en valeur (en amplitude), la phase de l'oscillation de l'oscillateur de conversion (10) qui pilote le convertisseur (5) est influencée par un signal pilote dérivé du signal à amplifier de façon telle qu'au total il se produit une amplification linéaire.

2. Procédé selon la revendication 1, caractérisé en ce que l'on obtient l'accroissement plus que proportionnel de la tension de sortie (3) du réseau de distorsion (2) par le moyen que l'on répartit la tension d'entrée (1) à amplifier sur deux chemins, étant précisé que sur l'un des chemins on met en circuit un réseau partiel de distorsion à caractéristique d'expanseur (6) et que sur l'autre chemin on met en circuit un réseau partiel de distorsion à caractéristique de compresseur (7); et par le moyen que l'on regroupe à nouveau, pour donner une tension de sortie, les signaux de sortie des deux réseaux partiels de distorsion à l'aide d'un montage à bifurcation (termineur) (8).

3. Procédé selon la revendication 1 ou la revendication 2, caractérisé en ce que l'on redresse linéairement la tension de sortie (3) du réseau de distorsion (2); en ce qu'avec cette tension redressée on pilote un modulateur de phase (9) qui modifie l'angle de phase d'un oscillateur auxiliaire (10); et en ce qu'avec le signal de sortie du modulateur de phase (9), utilisé comme signal oscillateur de conversion, on pilote le convertisseur (5) de façon telle que l'on compense les déphasages causés par l'amplificateur émetteur micro-onde (4) et ceux causés par la prédistorsion en valeur (en amplitude).

**Claims**

1. Method for the wide band linearisation of microwave transmitting amplifiers, particularly of travelling wave valves, on the principle of the signal predistortion by means of distorting networks, wherein a predistortion in terms of amplitude and phase takes place in dependence on the input amplitude so that altogether a linear amplification arises and wherein the signal input voltage (1) to be amplified is distorted by means of a distorting network (2) in such a manner that the output voltage (3) of the distorting network (2) linearises the microwave transmitting amplifier (4) in terms of amount, characterised thereby, that the predistortion in terms of amplitude takes place in the intermediate frequency plane and that during the subsequent frequency conversion into the high frequency plane of the signal predistorted in terms of amount, the phase of the oscillation of the conversion oscillator (10) controlling the converter (5) is additionally so influenced by a control signal derived from the signal to be amplified that altogether a linear amplification arises.

2. Method according to claim 1, characterised thereby, that the more than proportional rise in the output voltage (3) of the distorting network (2) is attained thereby, that the input voltage (1) to be amplified is divided over two paths, wherein a partial distorting network with expander characteristic (6) is connected into the one path and a partial distorting network with compressor characteristic (7) is connected into the other path and that the output signals of both the partial distorting networks are combined again into one output voltage by a fork circuit (8).

3. Method according to claim 1 or 2, characterised thereby, that the output voltage (3) of the distorting network (2) is rectified linearly, that a phase modulator (9) is controlled by this rectified voltage and varies the phase angle of an auxiliary oscillator (10) and that the converter (5) is so driven by the phase modulator (9) output signal, which is used as conversion oscillator signal, that the phase errors caused by the microwave transmitting amplifier (4) and by the predistortion in terms of amount are compensated for.

# FIG.1

# FIG.2

FIG.3

R$_{K1}$    R$_{K2}$    R$_{K3}$

1    D 1    D 2    3    D 3

2

U$_{D1}$    U$_{D2}$    U$_{D3}$

FIG.4

7

2

1    8    6    8    3

FIG.5

13    14    15

9

16

12    10

17

3    11    5    18    4

FIG. 6a

FIG. 6b